# EUROPÄISCHE PATENTSCHRIFT

(11) **EP 1 102 823 B1**
(45) Veröffentlichungstag und Bekanntmachung des Hinweises auf die Patenterteilung: **27.07.2005**
(21) Anmeldenummer: 99939977.7
(22) Anmeldetag: 01.07.1999
(51) Int. Cl.: C09J 7/02, C09J 7/00, C09J 9/02, H01L 21/60, H01L 23/498, H01R 4/04, H01R 13/03, H05K 3/32

(54) **ELEKTRISCH LEITFÄHIGE, THERMOPLASTISCHE UND HITZEAKTIVIERBARE KLEBSTOFFFOLIE**
ELECTROCONDUCTIVE, THERMOPLASTIC AND HEAT-ACTIVATED ADHESIVE FILM
FILM ADHESIF ELECTROCONDUCTEUR, THERMOPLASTIQUE ET THERMO-ACTIVABLE

(30) Priorität: 04.07.1998 DE 19830021; 20.03.1999 DE 19912628
(43) Veröffentlichungstag der Anmeldung: 30.05.2001
(73) Patentinhaber: tesa AG, 20253 Hamburg (DE)
(72) Erfinder: PFAFF, Ronald, D-22335 Hamburg (DE); ENGELDINGER, Hans, Karl, D-25451 Quickborn (DE)
(86) Internationale Anmeldenummer: PCT/EP1999/004539
(87) Internationale Veröffentlichungsnummer: WO 2000/001782

(56) Entgegenhaltungen:
- EP-A- 0 134 623
- EP-A- 0 140 619
- EP-A- 0 846 743
- WO-A-98/03047
- PATENT ABSTRACTS OF JAPAN vol. 1996, no. 08, 30. August 1996 (1996-08-30) & JP 08 111426 A (TOSHIBA CHEM CORP), 30. April 1996 (1996-04-30)

## Beschreibung

Die Erfindung beschreibt eine elektrisch leitfähige, thermoplastische und hitzeaktivierbare Klebstoffolie, wie sie zur dauerhaften Verbindung von zwei Gegenständen verwendet wird.

Elektronische Bauteile werden zunehmend kleiner, wodurch ihre Handhabung und Verarbeitung immer weiter erschwert wird. Vor allem beim Herstellen von elektrischen Kontakten zwischen den Bauteilen und/oder den Anschlüssen zeigt sich, daß herkömmliches Löten die entsprechenden Kontakte nicht mehr einfach und kostengünstig verbinden kann.
Die Verklebung elektronischer Bauteile durch elektrisch leitfähige Klebstoffschichten ist deshalb eine sich entwickelnde Alternative.

Für den Bereich der elektrisch leitfähigen Klebebänder ist es Stand der Technik, leitfähige Pigmente wie Ruß, Metallpulver, ionische Verbindung u.ä. in Klebemassen einzusetzen.
Bei ausreichenden Mengen berühren sich die Partikel untereinander und die Möglichkeit des Stromflusses von Partikel zu Partikel ist gegeben. Der Stromfluß ist hier nicht richtungsorientiert (isotrop); für spezielle Anwendungen wie elektronische Schalter, Kontaktierung von Leitern etc. besteht aber die Forderung, elektrische Leitfähigkeit nur in Dickenrichtung (z-Richtung) durch das Klebeband zu erzielen, dafür aber keine Leitfähigkeit in der flächigen Ausdehnung (x-y-Ebene) der Klebeschicht.

In speziellen Fällen ist ferner sicherzustellen/zu fordern, daß die leitfähigen Stellen durch die Klebeschicht (in z-Richtung)
- homogen verteilt sind, so daß beliebige Stellen des Klebebands
- identisch verwendet und zu gleichen Ergebnissen führen;
- kleine Querschnitte haben, um auch im Bereich der Elektronik eng zusammen liegende Leiterbahnen selektiv ohne Gefahr von Kurzschlüssen verbinden zu können und daß
- die leitfähigen Stellen untereinander isoliert sind, indem die Zwischenräume mit nicht leitenden Materialien ausgefüllt sind.

Das US-Patent US 3,475,213 beschreibt statistisch verteilte sphärische Partikel, die ganz aus einem leitfähigen Metall bestehen oder mit einer elektrisch leitfähigen Schicht versehen sind. Die besten Ergebnisse werden mit Partikeln erzielt, die nur wenig kleiner sind, als die Dicke der Klebemasseschicht ist.

Mit dem US-Patent US 5,300,340 wurden durch ein spezielles Herstellverfahren mit einer rotierenden Trommel, die elektrisch leitfähige Partikel in die Klebemasse plaziert.

Beide der oben beschriebenen Haftklebebänder basieren auf selbstklebenden Acrylatpolymerklebemassen und können zwei Substrate nicht mit einer Festigkeit verbinden, wie sie für eine dauerhafte Verklebung vonnöten ist. Vor allem Verbindungen, die dauerhaft oder wiederholt belastet werden, wie zum Beispiel durch Zug-, Torsions- oder Scherkräfte, zeigen bereits nach kurzer Zeit Ablöseerscheinungen. Das liegt darin begründet, daß beim zitierten Stand der Technik die generell niedrige Klebkraft der PSA-Klebebänder durch den Zusatz von elektrisch leitenden Partikel weiter herabgesetzt wird. Die Verbindungstechniken sind deshalb nicht ausreichend, um dauerhafte Verbindung bei mechanisch beanspruchten elektronischen Kontakten zu gewährleisten.

Die zugefügten Partikel setzen zum einen die Verklebungsfestigkeit herab, zum anderen bewirken sie einen Abstand des Klebebands zur Oberfläche, da die Partikel zu einem gewissen Grad aus der Oberfläche herausragen, was zur Verbesserung der elektrischen Leitfähigkeit durchaus erwünscht ist.

Bei einem Produktaufbau, wie sie das US-Patent US 5,300,340 beschreibt, nutzt man diesen bewußt, indem man größere Partikel einmischt, die einen Durchmesser aufweisen, der oberhalb der Dicke der Klebemasse liegt.

Die oben vorgestellten Verfahren zeigen nicht nur unzureichende Verbindungsfestigkeiten für mechanische beanspruchte elektrische Kontakte, sie lassen sich auch wieder lösen, wodurch Manipulationen möglich sind und Urheberrechte insbesondere bei sensiblen elektronischen Bauteilen leicht verletzt werden können.
Vor allem bei elektronischen Geräten, die klein und flexibel sind und die in elektronischem Spielzeug oder Chipkarten verwendet werden, ist die elektrisch leitende Klebeverbindung häufig nicht durch ein starres Gehäuse geschützt, muß Biegebelastungen standhalten, ohne den elektrischen Kontakt zu verlieren, und ist für solche Manipulation anfällig.

Der Erfindung liegt die Aufgabe zugrunde, bei einer Verklebung eines Trägerelements in Datenträgem oder elektronischen Bauteilen mit Hilfe einer thermoaktivierbaren Klebeschicht eine gute und dauerhafte Verbindung zu erzielen bei gleichzeitiger Herstellung eines elektrisch leitfähigen Kontaktes.

Gelöst wird diese Aufgabe durch eine Klebstoffolie, wie sie in dem Hauptanspruch näher gekennzeichnet ist. Gegenstand der Unteransprüche sind vorteilhafte Weiterbildungen des Erfindungsgegenstands.

Erfindungsgemäß enthält die elektrisch leitfähige, thermoplastische und hitzeaktivierbare Klebstoffolie
i) ein thermoplastisches Polymer mit einem Anteil von 30 bis 89,9 Gew.-%,
ii) ein oder mehrere klebrigmachende Harze mit einem Anteil von 5 bis 50 Gew.-% und/oder
iii) Epoxidharze mit Härtern, gegebenenfalls auch Beschleunigern, mit einem Anteil von 5 bis 40 Gew.-%.
iv) versilberte Glaskugeln mit einem Anteil von 0,1, ganz besonders bevorzugt 10 Gew.-%, bis 40 Gew.-%.

Die Klebstoffolie ist eine Mischung von reaktiven Harzen, die bei Raumtemperatur vernetzen und ein dreidimensionales, hochfestes Polymemetzwerk bilden, und von dauerelastischen Elastomeren, die einer Versprödung des Produktes entgegenwirken. Das Elastomer kann bevorzugt aus der Gruppe der Polyolefine, Polyester, Polyurethane oder Polyamide stammen oder ein modifizierter Kautschuk sein, wie zum Beispiel Nitrilkautschuk.

Die insbesondere bevorzugten thermoplastischen Polyurethane (TPU) sind als Reaktionsprodukte aus Polyester- oder Polyetherpolyolen und organischen Diisocyananten wie Diphenylmethandiisocyanat bekannt. Sie sind aus überwiegend linearen Makromolekülen aufgebaut. Solche Produkte sind zumeist in Form elastischer Granulate im Handel erhältlich, zum Beispiel von der Bayer AG unter dem Handelsnamen "Desmocoll".

Durch Kombination von TPU mit ausgewählten verträglichen Harzen kann die Erweichungstemperatur der Klebstoffolie ausreichend gesenkt werden, so daß eine Verformung des Kartenkörpers während des Herstellungsprozesses ausgeschlossen ist. Parallel dazu tritt sogar eine Erhöhung der Adhäsion auf. Als geeignete Harze haben sich beispielsweise bestimmte Kolophonium-, Kohlenwasserstoff- und Cumaronharze erwiesen.

Alternativ dazu kann die Reduzierung der Erweichungstemperatur der Klebstoffolie durch die Kombination von TPU mit ausgewählten Epoxidharzen auf der Basis von Bisphenol A und/oder F und einem latenten Härter erreicht werden. Eine Klebstoffolie aus einem derartigen System erlaubt ein Nachhärten der Klebfuge, entweder allmählich bei Raumtemperatur ohne jeden weiteren äußeren Eingriff oder kurzzeitig durch eine gezielte Temperierung der Karten nach der Herstellung. Auf diese Weise kann ein späteres, zerstörungsfreies Herauslösen des Chips in krimineller Absicht, zum Beispiel unter Verwendung eines üblichen Bügeleisens, unterbunden werden. Durch die chemische Vemetzungsreaktion der Harze werden große Festigkeiten zwischen dem Klebefilm und der zu verklebenden Oberfläche erzielt und eine hohe innere Festigkeit des Produktes erreicht.

Die Zugabe dieser reaktiven Harz/Härtersystemen führt dabei auch zu einer Erniedrigung der Erweichungstemperatur der oben genannten Polymere, was ihre Verarbeitungstemperatur und -geschwindigkeit vorteilhaft senkt. Das geeignete Produkt ist ein bei Raumtemperatur oder leicht erhöhten Temperaturen selbsthaftendes Produkt. Beim Erhitzen des Produktes kommt es kurzfristig auch zu einer Erniedrigung der Viskosität wodurch das Produkt auch rauhe Oberflächen benetzen kann.

Die in der Klebstoffolie enthaltenen Kugeln ermöglichen lediglich eine Leitfähigkeit in z-Richtung; in der x-y-Ebene kommt wegen der fehlenden Berührung untereinander keine Leitfähigkeit zustande.

Die Zusammensetzungen für die Klebstoffolie lassen sich durch Veränderung von Rohstoffart und -anteil in weitem Rahmen variieren. Ebenso können weitere Produkteigenschaften wie beispielsweise Farbe, thermische oder elektrische Leitfähigkeit durch gezielte Zusätze von Farbstoffen, mineralischen bzw. organischen Füllstoffen und/oder Kohlenstoff- bzw. Metallpulvern erzielt werden.

Vorzugsweise weist die Klebstoffolie eine Dicke von 20 bis 500 µm auf.

Der Durchmesser der versilberten Glaskugeln ist in einer ersten vorteilhaften Ausführungsform der Erfindung zumindest gleich der Dicke der Klebstoffolie, kann aber auch etwas über der Dicke der herzustellenden Klebstoffolie liegen.

In einer alternativen vorteilhaften Ausführungsform der Klebstoffolie ist der Durchmesser der Glaskugeln zwischen 10 µm und 20 µm geringer als die Dicke der Klebstoffolie.

Welcher Durchmesser der Glaskugeln erfindungsgemäß gewählt wird, ist vom jeweiligen Einsatzzweck der Klebstoffolie abhängig.

Wenn der Durchmesser der Glaskugeln oberhalb der Klebstoffoliendicke liegt, können aus der Klebstoffolie herausragende Glaskugeln zu unerwünschten Lufteinschlüssen in der Klebefuge führen, was die Verbindungsstärke herabsetzen kann. Unter ungünstigen Bedingungen kann dies dazu führen, daß die Glaskugeln in einer elastischen Klebefuge bei mechanischen Belastungen den Kontakt verlieren, der erst durch erneutes Verpressen wieder hergestellt werden kann.

Bei einigen Anwendungen steht daher die Verbindungsfestigkeit gegenüber der Leitfähigkeit im Vordergrund. Dabei muß bei hohem Druck und bei erhöhter Temperatur verklebt werden. In diesem speziellen Fall kann auf aus der Klebstoffolie herausragende, elektrisch leitfähige Glaskugeln verzichtet werden.
Die leitfähigen Glaskugeln können dann etwa 10 bis 20 µm kleiner als die Dicke der Klebstoffolie sein und damit ein leichtes Anheften und vollflächiges Verkleben ohne Lufteinschlüsse ermöglichen.
Die elektrischer Kontakt wird trotzdem hergestellt, da bei diesen Verklebungsbedingungen die Viskosität der Klebemasse so sehr erniedrigt wird, daß sie verdrängt und die Dicke der Klebfuge verringert wird. Dies geschieht zum Beispiel beim Verkleben von Modulen in Smart Cards. Hier wird ein Druck von 60 N pro Modul und eine Stempeltemperatur von ca. 200 °C gewählt. Unter diesen Bedingungen erhalten die leitfähigen Glaskugeln einen elektrisch leitfähigen Kontakt, da die Klebemasse verdrängt wird und in einen Hohlraum unter dem Chipmodul ausweichen kann.

Wichtig ist dies zum Beispiel bei der Modulimplantierung in eine Karte mit einer Antenne in dem Kartenkörper.

Besonders vorteilhaft kann die erfindungsgemäße Klebstoffolie eingesetzt werden zum Implantieren von elektrischen Modulen in einen Kartenkörper, der mit einer Aussparung versehen ist, in die ein elektronisches Modul anzuordnen ist, das auf der ersten Seite mehrere Kontaktflächen und auf der der ersten Seite gegenüberliegenden zweiten Seite einen IC-Baustein aufweist, dessen Anschlußpunkte über elektrische Leiter mit den Kontaktflächen verbunden sind, wobei die Klebstoffolie zur Verbindung der zweiten Seite des Moduls mit dem Kartenkörper dient.

Vorzugsweise hat in diesem Falle die Klebstoffolie die gleichen Maße wie das Modul und liegt als Stanzling vor.

Darüber hinaus ist auch die Verwendung der Klebstoffolie zum strukturellen Kleben, gegebenenfalls mit anschließender Hitzehärtung, möglich.

Die Erfindung beschreibt eine elektrisch leitfähige, thermoplastische und hitzeaktivierbare Klebstoffolie, wie sie zur dauerhaften Verbindung von zwei Gegenständen verwendet wird. Im Gegensatz zu Verklebungen mit einem Haftklebeband werden hierbei Festigkeiten, wie sie im konstruktiven Bereich benötigtwerden, dauerhaft erreicht und auch bei chemischen, thermischen oder klimatischen Belastungen beibehalten.

Zur Herstellung der Klebstoffolie wird die die Folie bildende Masse als Lösung auf ein flexibles Substrat (Trennfolie oder Trennpapier) gegossen und getrocknet, so daß die Masse von dem Substrat leicht wieder entfernt werden kann.

Nach entsprechender Konfektionierung können Stanzlinge oder Rolle von dieser Klebstoffolie bei Raumtemperatur oder bei leicht erhöhter Temperatur auf das zu verklebende Substrat (elektronisches Bauteil, Modul etc.) aufgeklebt werden.

Die zugemischten reaktiven Harze sollten bei der leicht erhöhten Temperatur noch keine chemische Reaktion eingehen. So muß die Verklebung nicht als einstufiges Verfahren erfolgen, sondern auf eines der beiden Substrate kann einfachheitshalber, wie bei einem Haftklebeband, zunächst die Klebstoffolie geheftet werden, indem man in der Wärme laminiert. Beim eigentlichen Heißklebeprozess mit dem zweiten Substrat härtet das Harz dann ganz oder teilweise aus und die Klebefuge erreicht die hohe Verklebungsfesfigkeit, weit oberhalb denen von Haftklebesystemen.
Die Klebstoffolie ist dementsprechend insbesondere für ein Heißverpressen bei Temperaturen unter 120 °C, insbesondere bei 80 bis 100 °C, geeignet.

Anders als leitfähig gefüllte Flüssigkleber oder Klebepasten, die meist zur isotrop leitfähigen Verbindung geeignet sind, härtet die beschriebene Klebstoffolie aber nicht zu einem spröden Film aus, sondern bleibt durch das ausgewogene Verhältnis von Vemetzerharz und elastischen Kautschuk in einem zähelastischen Zustand, wodurch insbesondere Schälbewegungen und - Beanspruchungen gut überstanden werden könnten. Der große Vorteil des beschriebenen Klebefilms kommt überall dort zum Tragen, wo bisher eine Verklebung oder Befestigung und eine elektrisch leitende Verbindung in zwei separaten Schritten durchgeführt wurde. Das bedeutet in den allermeisten Fällen auch ein erhöhter Platzbedarf für Befestigung und leitfähiger Verknüpfung, was bei kleineren elektronischen Bauteilen von Nachteil ist. Auch benötigt der separat durchgeführte Verklebungsschritt eine spezielles Equipment und teure Maschinen.

Die erfindungsgemäßen Klebstoffolien zeichnen sich somit durch eine Reihe von Vorteilen aus:
- Sie besitzen eine hohe Kohäsion und Elastizität bei Raumtemperatur.
- Sie zeigen eine hohe Adhäsion auf den üblichen Chip-Kartenmaterialien wie beispielsweise PVC, PC, PET oder ABS.
- Sie sind aktivierbar unterhalb der Erweichungstemperatur der Kartenmaterialien.

Darüber hinaus weisen Chipkarten, deren Module mit einer erfindungsgemäßen Klebstoffolie eingeklebt werden, eine besonders hohe Biegefestigkeit auf. Dies beweist die Durchführung eines Dauerbiegetests unter ständigem Lastwechsel nach DIN EN 20 178.

Im folgenden soll anhand mehrerer Beispiele die erfindungsgemäße Klebstoffolie verdeutlicht werden, ohne die beschriebene Erfindung unnötig einschränken zu wollen.

### Beispiel 1

Die folgenden Bestandteile wurden in einem Aceton/Methy-ethyl-Keton-Gemisch gelöst und als Lösung auf ein silikonisiertes Papier aufgetragen und anschließend getrocknet.

| | Handelsname | Gew.-% |
|---|---|---|
| Thermoplast. PU (TPU) | Desmocoil 400 | 55 |
| Epoxidharz (Bisphenol A) | Rütapox 0164 | 25 |
| Dicyandiamid | Dyhard 100 S (SKW Trostberg) | 5 |
| versilberte Glaskugeln | Conductofil 20-60 | 15 |
| | | |
| Dicke der getrockneten Klebstoffolie | µm 58 | ASTM D 1000 |
| Gewicht des Klebstoffolie | g/m² 55 | ASTM D 1000 |
| Durchgangswiderstand | mΩ 3,5 | ASTM D 2739 |
| spez. Widerstand | Ωm 0,30 | ASTM D 2739 |
| Verklebungsfestigkeit | N/mm² 10 | DIN EN 1465 |

### Beispiel 2

Die folgenden Bestandteile wurden in einem Aceton/Methy-ethyl-Keton-Gemisch gelöst und als Lösung auf ein silikonisiertes Papier aufgetragen und anschließend getrocknet.

| **Substanzklasse** | | **Gew.-%** |
|---|---|---|
| Nitrilkautschuk | | 55 |
| Phenolharz | | 29,8 |
| Alterungsschutzmittel | | 0,2 |
| versilberte Glaskugeln | | 15 |
| | | |
| Dicke der getrockneten Klebstoffolie | µm 59 | ASTM D 1000 |
| Gewicht des Klebstoffolie | g/m² 55 | ASTM D 1000 |
| Durchgangswiderstand | mΩ 3,5 | ASTM D 2739 |
| spez. Widerstand | Ωm 0,32 | ASTM D 2739 |
| Verklebungsfestigkeit | N/mm² 7,0 | DIN EN 1465 |

## Patentansprüche

1. Elektrisch leitfähige, thermoplastische und hitzeaktivierbare Klebstofffolie, enthaltend
i) ein thermoplastisches Polymer mit einem Anteil von 30 bis 89,9 Gew.-%,
ii) ein oder mehrere klebrigmachende Harze mit einem Anteil von 5 bis 50 Gew.-% und/oder
iii) Epoxidharze mit Härtern, gegebenenfalls auch Beschleunigern, mit einem Anteil von 5 bis 40 Gew.-%,
iv) versilberte Glaskugeln mit einem Anteil von 0,1 bis 40 Gew.-%,
v) wobei der Durchmesser der Glaskugeln zumindest gleich der Dicke der Klebstofffolie ist.

2. Klebstofffolie nach Anspruch 1, **dadurch gekennzeichnet, dass** es sich beim thermoplastischen Polymer um thermoplastische Polyolefine, Polyester, Polyurethane oder Polyamide oder modifizierte Kautschuke, wie insbesondere Nitrilkautschuke, handelt.

3. Klebstofffolie nach den Ansprüchen 1 und 2, **dadurch gekennzeichnet, dass** die Klebstofffolie mit einem oder mehreren Additiven wie Farbstoffen, mineralischen bzw. organischen Füllstoffen, beispielsweise Siliziumdioxid, Kohlenstoffpulvern und Metallpulvern abgemischt ist.

4. Thermoplastische Klebstofffolie nach den Ansprüchen 1 bis 3, **dadurch gekennzeichnet, dass** die Klebstofffolie eine Dicke von 20 bis 500 µm aufweist.

5. Thermoplastische Klebstofffolie nach den Ansprüchen 1 bis 4, **dadurch gekennzeichnet, dass** die Klebstofffolie für ein Heißverpressen bei Temperaturen unter 120 °C, insbesondere bei 80 bis 100 °C, geeignet ist.

6. Thermoplastische Klebstofffolie nach den Ansprüchen 1 bis 5, **dadurch gekennzeichnet, dass** die Klebstofffolie die gleichen Maße wie das Modul hat und als Stanzling vorliegt.

7. Verwendung einer Klebstofffolie nach einem der Ansprüche 1 bis 6 zum Implantieren von elektrischen Modulen in einen Kartenkörper, der mit einer Aussparung versehen ist, in die ein elektronisches Modul anzuordnen ist, das auf der ersten Seite mehrere Kontaktflächen und auf der der ersten Seite gegenüberliegenden zweiten Seite einen IC-Baustein aufweist, dessen Anschlusspunkte über elektrische Leiter mit den Kontaktflächen verbunden sind, wobei die Klebstofffolie zur Verbindung der zweiten Seite des Moduls mit dem Kartenkörper dient.

8. Verwendung einer Klebstofffolie nach einem der Ansprüche 1 bis 6 zum strukturellen Kleben, gegebenenfalls mit anschließender Hitzehärtung.

## Claims

1. Electrically conductive, thermoplastic and heat-activatable adhesive film, comprising
i) a thermoplastic polymer in a proportion of from 30 to 90% by weight,
ii) one or more tackifying resins in a proportion of from 5 to 50% by weight and/or
iii) epoxy resins with hardeners, with or without accelerators, in a proportion of from 5 to 40% by weight, and
iv) silver-coated glass beads in a proportion of from 0.1 to 40% by weight,
v) where the diameter of the glass beads is at least equal to the thickness of the adhesive film.

2. Adhesive film according to Claim 1, **characterized in that** the thermoplastic polymer comprises thermoplastic polyolefins, polyesters, polyurethanes or polyamides or modified rubbers, such as nitrile rubbers in particular.

3. Adhesive film according to Claim 1, **characterized in that** the adhesive film is blended with one or more additives, such as colorants, mineral or organic fillers, such as silica, carbon powders and metal powders.

4. Thermoplastic adhesive film according to Claim 1, **characterized in that** the adhesive film has a thickness of from 20 to 500 µm.

5. Thermoplastic adhesive film according to Claim 1, **characterized in that** the adhesive film is suitable for hot pressing at temperatures below 120°C, in particular from 80 to 100°C.

6. Thermoplastic adhesive film according to Claim 1, **characterized in that** the adhesive film has the same dimensions as the module and is in the form of a punched film section.

7. Use of an adhesive film according to one of Claims 1 to 6 for implanting electrical modules in a card body provided with a cutout for accommodating an electronic module which on the first side has a plurality of contact surfaces and on the second side, which is opposite the first side, has an IC chip whose terminals are connected via electrical conductors to the contact surfaces, the adhesive film being used to connect the second side of the module to the card body.

8. Use of an adhesive film according to one of Claims 1 to 6 for structural bonding, with or without subsequent heat-curing.

## Revendications

1. Feuille adhésive électriquement conductrice, thermoplastique et thermoactivable contenant
i) un polymère thermoplastique en une proportion de 30 à 89,9% en poids,
ii) une ou plusieurs résines poisseuses en une proportion de 5 à 50% en poids et/ou
iii) des résines époxyde avec des' durcisseurs, le cas échéant également des accélérateurs, en une proportion de 5 à 40% en poids,
iv) des billes de verre argentées en une proportion de 0,1 à 40% en poids,
v) le diamètre des billes de verre étant au moins identique à l'épaisseur de la feuille adhésive.

2. Feuille adhésive selon la revendication 1, **caractérisée en ce que**, pour le polymère thermoplastique, il s'agit de polyoléfines, polyesters, polyuréthannes ou polyamides thermoplastiques ou de caoutchoucs modifiés, tels qu'en particulier de caoutchoucs de nitrile.

3. Feuille adhésive selon les revendications 1 et 2, **caractérisée en ce que** la feuille adhésive est mélangée avec un ou plusieurs additifs, tels que des colorants, des charges minérales ou, selon le cas, organiques, par exemple le dioxyde de silicium, des poudres de carbone et des poudres métalliques.

4. Feuille adhésive thermoplastique selon les revendications 1 à 3, **caractérisée en ce que** la feuille adhésive présente une épaisseur de 20 à 500 µm.

5. Feuille adhésive thermoplastique selon les revendications 1 à 4, **caractérisée en ce que** la feuille adhésive convient pour une thermocompression à des températures inférieures à 120°C, en particulier de 80 à 100°C.

6. Feuille adhésive thermoplastique selon les revendications 1 à 5, **caractérisée en ce que** la feuille adhésive présente les mêmes dimensions que le module et existe sous forme d'une pièce découpée.

7. Utilisation d'une feuille adhésive selon l'une quelconque des revendications 1 à 6 pour implanter des modules électriques dans un corps de circuit, pourvu d'un évidement, dans lequel doit être agencé un module électronique qui présente d'un côté plusieurs surfaces de contact et sur le deuxième côté, opposé au premier, un élément IC, dont les points de contact sont reliés -via des conducteurs électriques avec les surfaces de contact, la feuille adhésive servant à l'assemblage du deuxième côté du module avec le corps du circuit.

8. Utilisation d'une feuille adhésive selon l'une quelconque des revendications 1 à 6 pour le collage structurel, le cas échéant suivi d'un thermodurcissement.
